Europäisches Patentamt

European Patent Office

Office européen des brevets

(19)

(11) Publication number: **0 138 126**
A2

(12)

# EUROPEAN PATENT APPLICATION

(21) Application number: **84111608.0**

(22) Date of filing: **28.09.84**

(51) Int. Cl.⁴: **H 03 K 19/094**

(30) Priority: **30.09.83 JP 183426/83**

(43) Date of publication of application: **24.04.85**
**Bulletin 85/17**

(84) Designated Contracting States: **DE FR GB**

(71) Applicant: **NEC CORPORATION, 33-1, Shiba 5-chome, Minato-ku, Tokyo 108 (JP)**

(72) Inventor: **Machida, Toshiaki, c/o NEC Corportion 33-1, Shiba 5-chome, Minato-ku Tokyo (JP)**

(74) Representative: **Glawe, Delfs, Moll & Partner Patentanwälte, Postfach 26 01 62 Liebherrstrasse 20, D-8000 München 26 (DE)**

(54) **Logic circuit with low power structure.**

(57) A CMOS logic circuit fabricated on a reduced area of a semiconductor substrate and operating with low power consumption. A load circuit supplies a first potential to an output terminal; a logic section selectively supplies a second potential to the output terminal; and a data hold circuit or latch holds data at the output terminal when the load circuit is cut off during standby.

## LOGIC CIRCUIT WITH LOW POWER STRUCTURE

### BACKGROUND OF THE INVENTION

The present invention relates to a logic circuit and, more particularly, to a multi-input logic circuit having a CMOS construction.

An advantage of using CMOS construction for logic circuits is that such circuits exhibit low power consumption. As is well known, the circuit structure of multi-input logic circuits of the CMOS type is sophisticated and a large number of transistors employed are in the circuit. For example, a NOR gate of the CMOS type is composed of a plurality of parallel connected N-channel input transistors, each receiving an input signal, and an equal number of series connected P-channel load transistors. Because of the series connection, each of the load transistors must be made relatively large to obtain a desired load characteristic. Therefore, it has been difficult to form a CMOS type multi-input logic circuit with a small number of and small-sized transistors.

One approach which would avoid the above problem is to replace the multiple series load transistors with a single load transistor which is continuously in a conducting state. However, in this case, the normal CMOS advantage of low power consumption is partially lost.

## SUMMARY OF THE INVENTION

It is an object of the present invention to provide a multi-input logic circuit which can be fabricated on a small area and is suitable for high density integrated structure.

It is another object of the present invention to provide a multi-input logic circuit having low power consumption.

The logic circuit according to the present invention comprises a load circuit, a logic section including at least one data input transistor, the load circuit and the logic section being connected in series between voltage supply terminals, an output terminal at the intermediate junction of the load circuit and the logic section, and a latch circuit coupled to the output terminal for operatively holding the level at the output terminal, wherein the load circuit is enabled during an active period, and the latch circuit enabled for a standby period when the load circuit is disenabled.

According to the present invention, the load circuit is enabled during the active period, and the level of the output terminal is dependent upon the logic state of the logic section. In this period, the latch circuit is effectively disabled and does not affect on the level of the output terminal. During the standby period, the latch circuit is enabled to hold the level of the output terminal. The load circuit is disabled so that no current flows therethrough.

The load circuit can be formed with one small-sized FET, and it is easy to form the latch circuit on a small area. As a result, the circuit of the invention can be formed on the reduced area of a semiconductor substrate. Further, the circuit of the invention does not consume power during the standby period.

## BRIEF DESCRIPTION OF THE DRAWINGS

Fig. 1 is a circuit diagram showing a NOR circuit according to the prior art;

Fig. 2 is a circuit diagram showing another example of a NOR circuit according to the prior art;

Fig. 3 is a circuit diagram showing a NOR circuit according to the present invention;

Fig. 4 is a circuit diagram showing inverters employed in the circuit of Fig. 3;

Fig. 5 is a system diagram showing an application example of the circuit of Fig. 3; and

Figs. 6 and 7 show other examples of the logic section employed in the invention.

## DETAILED DESCRIPTION OF THE INVENTION

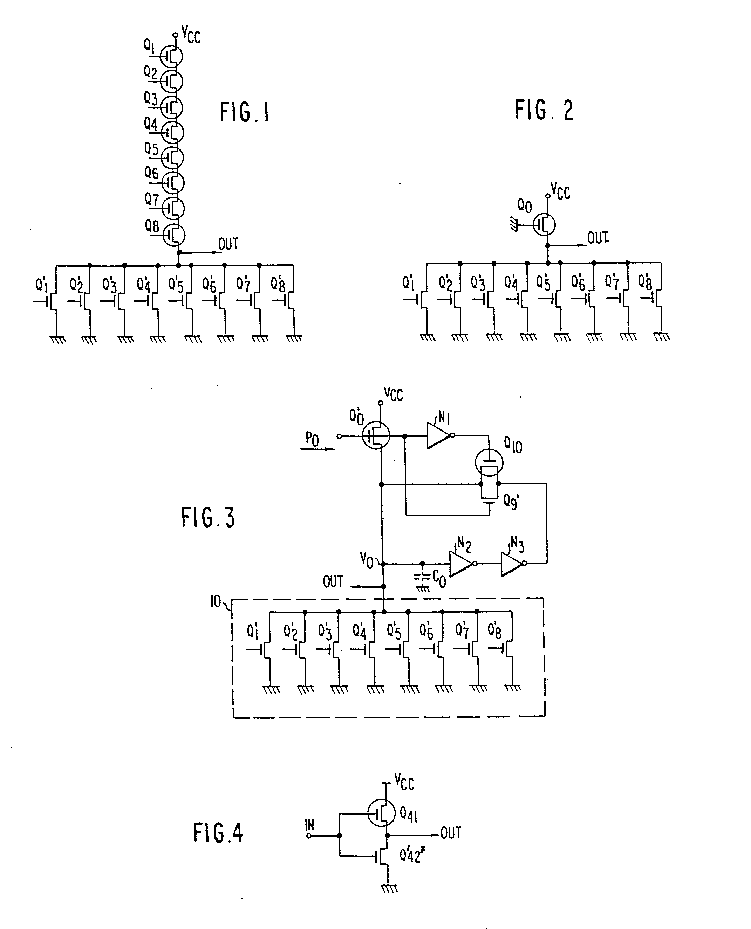

With reference to Fig. 1, an 8-input NOR circuit according to the prior art will be explained.

In Fig. 1, encircled elements $Q_1$ to $Q_8$ indicate P-channel MOS transistors, and elements $Q'_1$ to $Q'_8$ indicate N-channel MOS transistors. In order to obtain an N-input NOR circuit of a complete CMOS construction, P-channel and N-channel transistors are generally required in the same number N, respectively, and the P-channel transistors are connected in series as illustrated.

The operation of the prior art circuit is well understood. Typically, $Q'_1$ and $Q_1$ have their inputs tied together; $Q'_2$ and $Q_2$ have their inputs tied together; etc. For NOR logic, any "1" input results in a "0" output. For example, if any input is a logic "1", the $Q'_n$ transistor receiving the logic "1" will turn on and the $Q_n$ transistor will turn off. Thus, the output will be low, i.e., a logic "0". Only when all inputs are logic "0" will the output be a logic "1".

During the standby state, the output of a logic circuit does not drive subsequent circuitry but it is important not to alter the output as a result of the standby state. With the circuit of Fig. 1, there will be no power consumption during standby. If the output is a logic "0", i.e., at least one of the transistors $Q'_n$ is conducting, the path to $V_{cc}$ will be cut off. If the output is logic "1", the path to ground will be cut off.

In this circuit, in order to obtain a desired load characteristic, which, for example, is equivalent to the conductance G, each of the P-channel transistors $Q_1$ to $Q_8$ must have a conductance of $8 \cdot G$

according to Ohm's law.  In other words, if each of the P-channel transistors $Q_1$ to $Q_8$ is formed to have the conductance 8·G, the load characteristic of the series circuit formed of $Q_1$ to $Q_8$ will be equal to G. Assuming a fixed channel length, L, the conductance of an MOS transistor varies in proportion to its channel width.  Thus, each of the transistors $Q_1$ to $Q_8$ requires a channel width eight times greater than that which would be required by a single load transistor exhibiting the same load conductance as the series of eight transistors in combination.

As a result, the area of a semiconductor substrate for forming the circuit must be increased remarkably.

According to a typical example, the channel width of each of the P-channel transistors $Q_1$ to $Q_8$ is 160 microns and the channel length is 5 microns. The channel width of each of the N-channel transistors $Q'_1$ to $Q'_8$ is 10 microns and the channel length is 5 microns.  As a result, the area required for fabrication of this circuit is about 35,000 $\mu m^2$.

Another example of an 8-input NOR circuit of the CMOS type according to the prior art is shown in Fig. 2.  In this circuit, a single P-channel transistor $Q_0$ is employed as the load.  The gate of the transistor $Q_0$ is connected to ground potential so that the transistor is always in a conducting state.  The circuit provides a so-called ratio operation in which the P-channel MOS transistor $Q_0$ is always held in an operative state as the load transistor. The logic is exactly the same as it is for Fig. 1. According to this circuit construction, the number of the P-channel MOS transistors is reduced to the minimum, i.e., one, so that the area required for the elements can be reduced to the minimum. However, the defect concomitant with this circuit construction is that the power consumption is large in the standby state.

If the circuit is at a logic "1" just before standby, when standby occurs, all $Q'_n$ transistors will remain off, so that power consumption will be small. But if the circuit is in the logic "0" state, there will be a current path from $V_{cc}$ through $Q_0$ and through at least one $Q'_n$ to ground, resulting in relatively large power consumption during standby. As a result, with the circuit of Fig. 2, the low power consumption advantage of CMOS logic is partially lost.

The present invention will be described with reference to Fig. 3, which illustrates an 8-input NOR CMOS circuit embodying the present invention.

The logic circuit is composed of a logic section 10 formed of N-channel transistors $Q'_1$ to $Q'_8$, a P-channel transistor $Q'_0$ receiving a control signal $P_0$ at a gate thereof, and a latch circuit for operatively holding a logic signal $V_0$ at an output terminal OUT. The latch circuit consists of a P-channel transistor $Q_{10}$ and an N-channel transistor $Q'_9$ connected in parallel and inverters $N_1$, $N_2$ and $N_3$.

The input $P_0$ is at a low level when the circuit is not in the standby condition and at a high level when in the standby condition. Thus, during the operating (not standby) state, $Q'_0$ remains conducting. $Q_{10}$ and $Q'_9$ will be nonconducting, thereby effectively disabling the latching circuit. Thus, the circuit will operate exactly as the circuit of Fig. 2, provided $P_0$ is at a low level.

When $P_0$ is at a high level, designating the standby state, $Q'_0$ will be nonconducting. $Q'_9$ will conduct as a result of the high level of $P_0$. Also, the low level output from $N_1$ will render $Q_{10}$ conductive. As a result, conducting paths are provided between the output of inverter $N_3$ and the input of inverter $N_2$. The circuit then operates as a latch to retain at OUT the voltage level $V_0$ existing just prior to the standby state.

For example, assume the circuit is in the logic "1" state when $P_0$ is at the low level. All transistors $Q'_1-Q'_8$ are nonconducting and $Q'_0$ is conducting, providing a logic "1" output voltage $V_0$ to drive subsequent circuitry. If the standby period begins, $Q'_0$ will be cut off, but $Q_{10}$ and $Q'_9$ will

turn on. The logic "1" voltage at $V_0$ will be latched by the operation of inverters $N_2$ and $N_3$.

If the output had been a logic "0", i.e., one of transistors $Q'_1-Q'_8$ is conducting, it will remain at logic "0" when the standby state occurs.

The inverters are as shown in Fig. 4 and comprise a series connection of a P-channel transistor $Q_{41}$ and an N-channel transistor $Q'_{42}$. It will be appreciated that during the standby state when $V_0$ is a logic "1", the P-channel transistor $Q_{41}$ of $N_3$ will be conducting and the N-channel transistor $Q'_{42}$ will be nonconducting. Although a conducting path exists between $V_{cc}$, $Q_{41}$ (of $N_3$), $Q_{10}$ and $Q'_9$, and the OUT terminal, since none of the transistors $Q'_1-Q'_8$ is conducting there will be no path to ground and thus no power loss during this standby state.

On the other hand, in the standby state where the output is a logic "0", at least one of the transistors $Q'_1$ to $Q'_8$ will be conducting. However, in this state, $Q_{41}$ of $N_3$ will be nonconducting. Thus, there will not be a conducting path between $V_{cc}$ and ground.

The typical values of the channel width and the channel length of each of the transistors $Q'_1$ to $Q'_9$, $Q_{10}$ and $Q_{41}$ are 10 μm and 5 μm, respectively. The channel width and length of the transistor $Q'_0$ are 10 μm and 10 μm. Also, the channel width and length of each of the transistors $Q'_{41}$ are 7.5 μm and 5 μm, respectively. In this case, the circuit of Fig. 3 can be fabricated on an area of 18,000 $\mu m^2$, which is about half of that required for the circuit of Fig. 1.

In addition, the inverters $N_1$ to $N_3$ consume no steady current and hence the power consumption of the circuit of Fig. 3 is reduced to zero during the standby state.

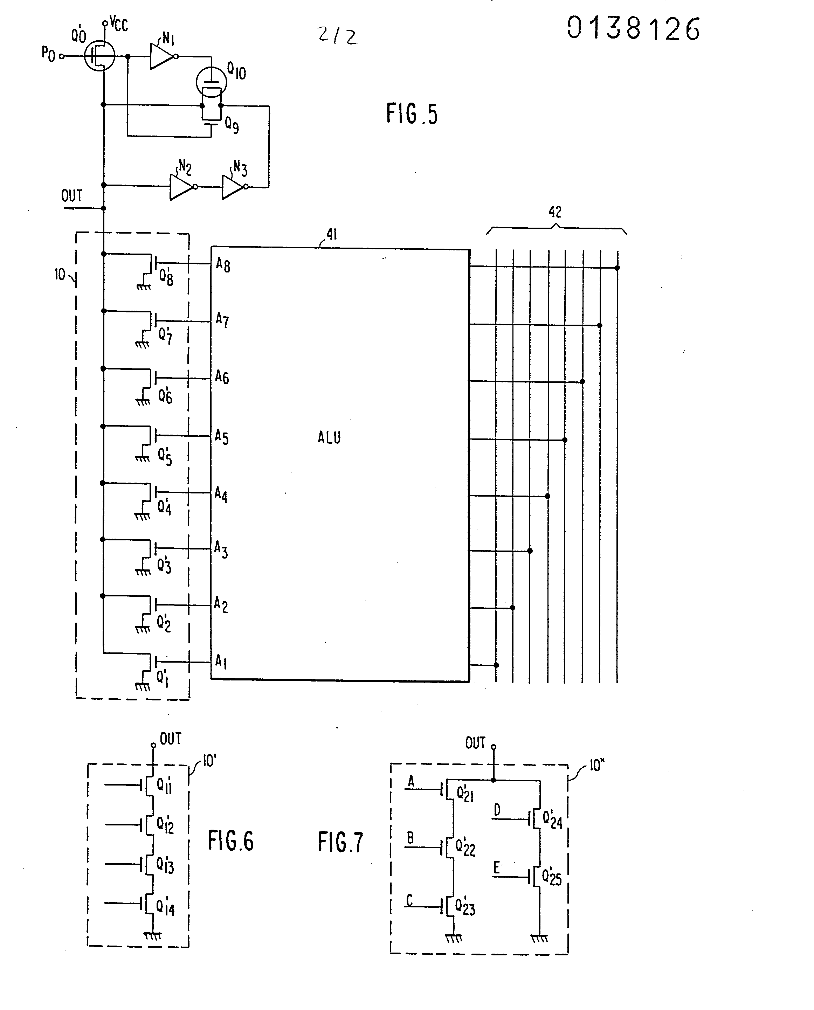

Fig. 5 shows an application example of the circuit of Fig. 3.

ALU 41 has parallel outputs $A_1$ to $A_8$ and interfaces with data bus line group 42. The outputs $A_1$ to $A_8$ are applied to the gates of the transistors $Q'_1$ to $Q'_8$, and the logic section 10 is used to detect that all the outputs $A_1$ to $A_8$ are at "0" level. When all the outputs $A_1$ to $A_8$ are at "0" level, then the output OUT takes "1" level.

It will be appreciated by anyone of ordinary skill in the art that the invention is not limited to any one type of logic combination, for the logic section 10 of the invention. The NOR logic is only exemplary. While the logic section may implement substantially any logic combination, two other logic combinations are illustrated in Figs. 6 and 7 merely to demonstrate this point.

Figs. 6 and 7 show variations 10' and 10", respectively, of the logic section 10. The logic section 10' is composed of serially connected input N-channel transistors $Q'_{11}$ to $Q'_{14}$ and performs an AND logic. The logic section 10" is composed of a series circuit of N-channel transistors $Q'_{21}$ to $Q'_{23}$ and a series circuit of N-channel transistors $Q'_{24}$ and $Q'_{25}$ to carry out the complex logic function:

$$OUT = (\bar{A} + \bar{B} + \bar{C}) \cdot (\bar{D} + \bar{E}).$$

As described above, the invention provides a CMOS logic circuit requiring less chip real estate than prior art CMOS circuits of the type shown in Fig. 1 and has lower power consumption during standby than the prior art CMOS circuits of the type shown in Fig. 2. The smaller size advantage exists even for the 8-input NOR gate of the exemplary embodiment, despite the fact that Fig. 3 uses one more transistor than does Fig. 1. The advantage in this embodiment is achieved because of the elimination of the very wide channel series connected transistors in the load circuit.

It will also be appreciated that the load and latch circuit of Fig. 3 will remain the same irrespective of any increase in the number of logic inputs to the logic section. For example, a 16-input NOR gate, like Fig. 3 would require only 9 transistors in the load and latch section. Thus, for increased logic, the present invention provides an even greater savings in chip real estate over the conventional circuitry.

11    0138126

CLAIMS

1. A logic circuit comprising a load circuit coupled between a first voltage terminal and an output terminal, a logic section including at least one input transistor receiving a logic input signal, said logic section being coupled between said output terminal and a second voltage terminal and selectively providing a current path therebetween, a latch circuit coupled to said output terminal for operatively holding the voltage level at said output terminal when enabled, means for enabling said load circuit during a first period and said latch circuit during a second period, different from said first period.

2. The circuit according to Claim 1, wherein said load circuit comprises a first field effect transistor of a first type conductivity.

3. The circuit according to Claim 2, wherein said logic circuit includes at least one field effect transistor of a second conductivity type.

4. The circuit according to Claim 3, wherein said latch circuit comprises a first inverter having an input terminal coupled to said output terminal, a second inverter having an input terminal receiving an output of said first inverter and a switch circuit coupled between said output terminal and the output of said second inverter.

5.   The circuit according to Claim 4, wherein each of said inverters is a two transistor CMOS inverter.

6.   The circuit according to Claim 4, wherein said logic section comprises a plurality of input field effect transistors of said second conductivity type receiving a plurality of logic input signals, said input transistors being connected in a configuration between said output terminal and said second voltage terminal to effect a desired logic function between the said logic input signals and the voltage level at said output terminal.

7.   The circuit according to Claim 6, wherein said load circuit consists of a single field effect transistor of said first type conductivity.

8.   The circuit according to Claim 7, wherein said first period is a nonstandby period for operation of said logic circuit, said second period is a standby period for said logic circuit, and wherein said means for enabling comprises means for connecting a period control signal to said load circuit transistor and said switch circuit to control the respective enablement of said load circuit transistor and said switch circuit.

9.   The circuit according to Claim 8, wherein said switch circuit comprises, a parallel circuit of a third field effect transistor of said first type conductivity and a fourth field effect transistor of said second type conductivity, said parallel circuit being coupled between said output terminal and the output of said second inverter, and a third inverter having an input connected to receive said period control signal and an output connected to the gate of said third transistor, the gate of said fourth transistor being connected to receive said period control circuit.

10. A logic circuit comprising a first field effect transistor of a first type conductivity adapted to operatively supply an output terminal with a first potential, first means for alternately making said first transistor conductive and nonconductive, a logic section including at least one second transistor of a second type conductivity and adapted to selectively supply said output terminal with a second potential, a data hold circuit coupled to said output circuit for operatively holding the level of said output terminal when said data hold circuit is enabled, and second means for enabling said hold circuit when said first transistor is nonconducting.

11. The logic circuit according to Claim 10, wherein said first means includes means for supplying the gate of said first transistor with a first control signal.

12. The logic circuit according to Claim 10, wherein said hold circuit includes first and second inverters connected in cascade, means for connecting

14    0138126

the input of said first inverter to said output terminal, and switching means coupled between said output terminal and the output of said second inverter.

13. The circuit according to Claim 12, wherein said switching means includes a parallel circuit of a third field effect transistor of said first conductivity and a fourth field effect transistor of said second conductivity.

FIG.1

FIG.2

FIG.3

FIG.4

0138126

FIG.5

ALU

42

41

10

OUT

FIG.6

FIG.7